# EUROPÄISCHE PATENTSCHRIFT

(11) **EP 2 380 738 B1**
(45) Veröffentlichungstag und Bekanntmachung des Hinweises auf die Patenterteilung: **28.05.2014**
(21) Anmeldenummer: 10004259.7
(22) Anmeldetag: 22.04.2010
(51) Int. Cl.: B41F 15/36, B41L 13/02, B41M 1/12, B41N 1/24, H05K 3/12, B41F 15/10, B41F 33/00

(54) **Drucksieb und Verfahren zur Einstellung der relativen Lage eines Druckmusters und eines Substrats**
Printing stencil and method for setting the relative position of a printed pattern and a substrate
Stencil d'impression et procédé de réglage de la position relative d'un motif d'impression et d'un substrat

(43) Veröffentlichungstag der Anmeldung: 26.10.2011
(73) Patentinhaber: Manz AG, 72768 Reutlingen (DE)
(72) Erfinder: Heim, Alexander, 72770 Reutlingen (DE); Schweitzer, Ulrich, 70567 Stuttgart (DE); Heintel, Matthias, 72768 Reutlingen (DE)
(74) Vertreter: Kohler Schmid Möbus

(56) Entgegenhaltungen:
- EP-A1- 0 247 742
- WO-A2-2008/100646
- DE-A1- 4 233 455
- DE-B4- 10 222 119
- JP-A- 63 207 646
- JP-A- 2007 021 913

## Beschreibung

Die Erfindung betrifft ein Drucksieb für ein Siebdruckverfahren mit einer Referenzmarke gemäß dem Oberbegriff des Anspruchs 1.

Siebdruckverfahren werden beispielsweise bei der Solarzellenherstellung eingesetzt, um Elektroden auf ein Substrat aufzudrucken. Eine zu druckende Struktur muss dabei bezüglich vorher eingebrachter Strukturen oder vorher aufgebrachter Strukturen ausgerichtet werden. Diese Ausrichtung kann erfolgen, indem das Substrat gegenüber einem lagefixierten Sieb positioniert wird oder ein verlagerbares Sieb gegenüber einem ortsfest fixierten Substrat orientiert wird. Eine Orientierung kann jedoch nur erfolgen, wenn die Lage der Struktur bekannt ist.

Aus der DE 102 22 119 B4 sind eine Vorrichtung und ein Verfahren zum Einstellen der relativen Lage zwischen einem zu bedruckenden Substrat und einem Druckmuster bekannt. Dabei wird vorgeschlagen, eine ... Beleuchtungsanordnung so anzuordnen, dass sie ein Sieb in einer abgehobenen Position des Siebes mit geringem Abstand zum abgelegten Substrat von der Seite eines Drucktisches aus beleuchten kann und eine lichtelektrische Anordnung so ausgestaltet und auf Seiten des Drucktisches angeordnet ist, dass sie das von dem Sieb diffus reflektierte Licht im Bereich von vorgegebenen Randabschnitten des abgelegten Substrats erfassen kann, jedoch kein von dem Substrat reflektiertes Licht. Dieses erfasste Licht kann hinsichtlich der Istlage des Randes des Substrats ausgewertet werden. Verstellsignale können abgeleitet und einer Verstelleinrichtung zugeführt werden.

Diese Vorgehensweise ist von den Reflexionseigenschaften des Siebs abhängig. Weiterhin muss verhindert werden, dass von dem Substrat reflektiertes Licht erfasst wird. Zudem kann sich die Kante des Substrats während der Substratbearbeitung verändern. Auch von Substrat zu Substrat können die Ränder/Kanten variieren, sodass die Lageerkennung des Substrats durch Erfassen seines Randbereichs ungenaue Ergebnisse liefert.

Die WO 2008/100646 A2 offenbart die Beleuchtung einer Leiterkarte mit zwei unterschiedlichen Lichtquellen, nämlich einer Lichtquelle, die langwelliges Licht aussendet, und einer Lichtquelle, die weißes Licht aussendet. Dadurch können feinere Strukturen besser detektiert werden.

Aus der EP 0 247 742 A1 ist ein Offsetdruckverfahren bekannt, bei dem einer Tinte Pigmente beigemischt sind, die bei Beleuchtung mit elektromagnetischer Strahlung, die außerhalb des sichtbaren Lichts liegt, detektierbar sind.

In der JP 2007-021913 wird vorgeschlagen, ein lumineszierendes Element und einen darüber liegenden Sensor zu verwenden, um zu detektieren, ob zwischen Sensor und lumineszierendem Element ein Blatt liegt.

Aus der DE 4233455 A1 ist ein Drucksieb gemäß dem Oberbegriff des Anspruchs 1 bekannt.

Aufgabe der vorliegenden Erfindung ist es daher, eine Möglichkeit bereitzustellen, die Lage eines Substrats beim Siebdruck genauer und zuverlässiger zu erfassen.

Gelöst wird diese Aufgabe gemäß einem ersten Aspekt der Erfindung durch ein Drucksieb für ein Siebdruckverfahren mit einer Referenzmarke, wobei die Referenzmarke ein lumineszierendes Material aufweist. Das von der lumineszierenden Referenzmarke ausgesandte Licht kann erfasst werden. Insbesondere kann anhand des erfassten Lichtes die Lage einer Referenzkante, die in Beziehung zur Lage einer Struktur des Substrats steht, zuverlässig erfasst werden. Wenn die Lage der Struktur bekannt ist, kann das Sieb entsprechend ausgerichtet werden. Insbesondere kann gezielt das Licht des lumineszierenden Materials erfasst werden, sodass keine Verfälschung des Messergebnisses durch reflektiertes Licht, insbesondere von der Solarzelle bzw. dem Substrat reflektiertes Licht, erfolgt.

Herkömmliche Drucksiebe weisen ein Gewebe auf. An denjenigen Stellen des Gewebes, an denen dem Druckbild entsprechend keine Bedruckung erfolgen soll, werden die Maschenöffnungen des Gewebes durch eine als Schablone wirkende Beschichtung in Form eines Siebfüllers oder einer Emulsion undurchlässig gemacht. Es ist daher auch denkbar, auf das Gewebe zu verzichten und nur eine Schablone zu verwenden, die Öffnungen aufweist, durch die Farbe oder Paste gedruckt wird. Auch das wird im Sinne der Erfindung als Drucksieb verstanden.

Gemäß einer bevorzugten Ausführungsform kann vorgesehen sein, dass das Drucksieb eine Referenzmarkenausnehmung aufweist, die mit dem lumineszierenden Material gefüllt ist. Die Referenzmarkenausnehmung kann dabei lediglich eine Vertiefung in der Maske (Schablone) des Drucksiebes oder im Drucksieb selbst sein (wenn kein Gewebe vorhanden ist), welche mit dem lumineszierenden Material gefüllt ist. Bei der Ausnehmung kann es sich jedoch auch um eine Öffnung in der Maske (Schablone) oder im Sieb (wenn kein Gewebe vorhanden ist) handeln, die zeitgleich mit Strukturen der Druckmaske auf- bzw. eingebracht wird und die dann mit dem lumineszierenden Material gefüllt wird. Die Referenzmarkenausnehmung kann rechteckig sein und neben den eigentlichen Druckstrukturen des Drucksiebes angeordnet sein. Hierbei ist zu erwähnen, dass mehrere Referenzmarken und Referenzmarkenausnehmungen vorgesehen sein können. Insbesondere können drei Referenzmarken vorgesehen sein, sodass die Lage des Substrats bzw. der Strukturen des Substrats genau erfasst werden kann.

Weitere Vorteile ergeben sich, wenn die Referenzmarke oder eine Referenzmarkenstruktur, insbesondere eine Kante der Referenzmarke, einen vorgegebenen Abstand zu einer Struktur des Siebs aufweist. Dabei kann die Referenzmarke aus zwei oder mehr Referenzmarkenstrukturen bestehen, deren Geometrie bekannt ist. Die Struktur des Siebs kann eine Referenzmarkenstruktur oder ein Tel einer Referenzmarke sein. Anhand eines bekannten Abstands zwischen zwei Referenzmarkenstrukturen bzw. einer Referenzmarke und einer Struktur ist eine Kalibrierung des Erfassungssystems möglich. Wenn die Erfassungseinrichtung eine Kamera umfasst, kann ein Bild einer ersten Referenzmarkenstruktur und der sich daran anschließenden zweiten Referenzmarkenstruktur erfasst werden. Wenn der Abstand zwischen der ersten Referenzmarkenstruktur und der zweiten Referenzmarkenstruktur bekannt ist, kann ein Verhältnis µm/Pixel bestimmt werden. Diese Kalibrierung ist wichtig, um beispielsweise thermische Effekte, die während des Betriebs auftreten können, ausgleichen zu können. Dieser Wert kann dadurch im Betrieb jederzeit bestimmt werden.

In einem weiteren Aspekt betrifft die Erfindung ein Verfahren zur Einstellung der relativen Lage eines Druckmusters und eines Substrats oder einer Struktur eines Substrats, bei dem das von einer lumineszierenden Referenzmarke eines das Druckmuster tragenden Siebs ausgesandte Licht in einem Bereich einer Referenzstruktur, die mit der Istposition des Substrats bzw. der Struktur des Substrats in Beziehung steht, erfasst wird und das erfasste Licht hinsichtlich der Istlage der Referenzstruktur ausgewertet und daraus die Verstellsignale für die Verstellung des Drucksiebes abgeleitet werden. Die Referenzstruktur kann sich dabei auf dem Substrat befinden. Als Referenzstruktur kann jedoch auch eine seitliche Kante des Substrats verwendet werden. Es ist außerdem denkbar, eine andere Referenzstruktur zu verwenden, die einen definierten Abstand bzw. eine bekannten Abstand zu einer Struktur des Substrats oder zu einer Kante des Substrats aufweist.

Besonders vorteilhaft ist es, wenn die Istlage einer Referenzkante eines das Substrat transportierenden Transportsystems erfasst wird. Wenn die Position des Substrats oder der Struktur des Substrats bezüglich der Referenzkante bekannt ist, kann durch Erfassung der Istlage der Referenzkante auch die Lage des Substrats bzw. einer Struktur des Substrats abgeleitet werden. Wenn wiederum die Istlage der Struktur oder des Substrats bekannt ist, kann das Drucksieb so verstellt werden, dass die Druckstrukturen in der richtigen Position auf das Substrat aufgedruckt werden.

Wenn die Referenzkante eines Transportsystems erfasst wird, muss das Substrat selbst nicht erfasst werden. Durch diese Maßnahme können störende Reflexionen des Substrats selbst vermieden werden. Auch Ungenauigkeiten aufgrund unterschiedlicher Ausgestaltungen der Kanten/Ränder der Substrate können ausgeschlossen werden.

Vorteilhafterweise werden die Relativposition des Substrats oder einer Struktur des Substrats zu einer Referenzkante des Transportsystems ermittelt. Dies geschieht vorteilhafterweise, ehe die Position der Referenzkante des Transportsystems unter Verwendung der lumineszierenden Referenzmarke des Siebs erfasst wird. Wenn nämlich die Relativposition des Substrats oder einer Struktur des Substrats zu einer Referenzkante des Transportsystems in einem vorhergehenden Schritt ermittelt wird, kann anschließend, nach Ermittlung der Istlage der Referenzkante des Transportsystems, einfach auf die Lage des Substrats bzw. der Struktur des Substrats geschlossen werden.

Dabei kann die Relativposition des Substrats oder einer Struktur des Substrats zu einer Referenzkante des Transportsystems in einem Durchlichtverfahren ermittelt werden. Beispielsweise kann das Transportsystem als Transportband ausgebildet sein, welches Öffnungen aufweist. Die Kante oder der Rand einer solchen Öffnung kann als Referenzstruktur dienen. Wenn Licht durch diese Öffnung hindurch gestrahlt wird, kann mittels einer über Transportband und Substrat angeordneten Kamera ein Abstand von einer Referenzkante der Öffnung zu einer Struktur des Substrats ermittelt werden. Wenn darüber hinaus das Substrat auf dem Transportband lagefixiert ist, ist die Lage der Struktur des Substrats relativ zum Transportband und damit zur Referenzkante bekannt. Diese Information kann später verwendet werden, um nach Erfassung der Position der Referenzkante des Transportbandes auf die Position der Struktur des Substrats zu schließen.

Weiterhin ist es vorteilhaft, wenn Licht von einer Beleuchtungseinrichtung in Richtung lumineszierender Referenzmarke des Siebs gestrahlt wird und das von der Referenzmarke abgestrahlte Licht gefiltert wird. Dadurch ist die Positionserfassung der Referenzkante ohne Einfluss von Streulicht durch die Beleuchtungseinrichtung. Weiterhin können sowohl eine Beleuchtungseinrichtung als auch eine Erfassungseinrichtung unterhalb des Siebs und vorzugsweise unterhalb eines Transportsystems angeordnet werden. Bei dieser Vorgehensweise kann die Wellenlänge gewechselt werden. Beispielsweise kann das Sieb von unten mit UV-Licht oder blauem Licht angestrahlt werden und kann im optischen Weg des von der lumineszierenden Fläche des Siebs abgegebenen Lichtes ein Filter, beispielsweise ein Gelbfilter, vorgesehen werden. Dadurch kann sichergestellt werden, dass nur Licht erfasst wird, welches von der lumineszierenden Referenzmarke abgegeben wird. Von dem Sieb oder dem Substrat reflektiertes Licht kann dadurch ausgefiltert werden. Dadurch wird verhindert, dass die Positionserfassung der Referenzstruktur verfälscht wird. Die Lage der Referenzstruktur kann unter dem Sieb somit im Durchlichtverfahren, ohne Einfluss anderer Messfehler, erfasst werden.

Es ist somit besonders vorteilhaft, wenn zur Bestrahlung der Referenzmarke Licht eines anderen Wellenlängenbereichs verwendet wird als für die Erfassung der Referenzstruktur.

In den Rahmen der Erfindung fällt weiterhin eine Siebdruckstation mit einem Drucksieb und einer Lichterfassungsanordnung, wobei als Drucksieb ein erfindungsgemäßes Drucksieb zum Einsatz kommt.

Vorteilhafterweise kann eine Beleuchtungseinrichtung zum Bestrahlen einer Referenzmarke des Drucksiebs mit einem ersten Wellenlängenbereich und ein optisches Filter zur Filterung des von der Referenzmarke abgesandten Lichtes in einem zweiten Wellenlängenbereich vorgesehen sein. Dadurch kann der Einfluss von Streulicht und von reflektiertem Licht vermieden werden. Mit der erfindungsgemäßen Siebdruckstation ist eine µm-genaue Lagevermessung des Transportsystems möglich. Dies lässt eine hochpräzise Korrektur eines Fehlers im Transportvektor des Transportsystems und einer damit verbundenen Verlagerung auf dem Transportsystem lagefixierten Substrats zu.

Besonders vorteilhaft ist es, wenn die Beleuchtungseinrichtung ringförmig ausgebildet ist und das optische Filter umgibt. Dadurch ergibt sich eine besonders platzsparende Anordnung von Beleuchtungseinrichtung und optischem Filter. Weiterhin müssen keine Umlenkeinrichtungen vorgesehen werden, um das von der lumineszierenden Referenzmarke abgegebene Licht zum Filter hin umzuleiten. Die oben erwähnte Lichterfassungsanordnung kann die Beleuchtungseinrichtung, das optische Filter, Umlenkspiegel und eine Kamera umfassen. In der Kamera implantiert oder der Kamera nachgeschaltet kann eine Bilderkennung und/oder -verarbeitung vorgesehen sein, sodass die Position der Referenzstruktur des Transportsystems anhand der aufgenommenen Bilder ermittelt werden kann.

Gemäß einer Ausgestaltung der Erfindung kann ein Transportsystem zum Transport eines zu bedruckenden Substrats vorgesehen sein, wobei das Transportsystem eine Referenzstruktur aufweist und eine Lichterfassungsanordnung vorgesehen ist, die von der lumineszierenden Referenzmarke des Drucksiebes ausgesandtes Licht in einem Bereich einer Referenzstruktur, die mit der Istposition der Struktur des Substrats in Beziehung steht, erfasst. Durch die Erfassung der Position des Transportsystems kann auf die Lage der Struktur des Substrats geschlossen werden. Eine unmittelbare Erfassung der Lage des Substrats bzw. der Struktur des Substrats ist somit nicht notwendig. Es ist eine besonders genaue und zuverlässige Positionierung des Drucksiebes bezüglich der Struktur des Substrats möglich, ohne die Struktur selbst erfassen zu müssen.

Das Transportsystem kann ein Transportband umfassen und die Referenzstruktur kann als Kante einer Öffnung im Transportband ausgebildet sein. Dabei kann das Transportband als Metallband ausgebildet sein. Durch diese Maßnahmen ergibt sich eine besonders einfache Ausgestaltung des Transportsystems und der Referenzstruktur im Transportsystem.

Weiterhin kann vorgesehen sein, dass das Transportband über einem Drucktisch angeordnet ist, das Substrat auf dem Transportband lagefixierbar ist und der Drucktisch eine Öffnung aufweist, innerhalb oder unterhalb der die Beleuchtungseinrichtung angeordnet ist. Dadurch ergibt sich eine kompakte, platzsparende Anordnung. Außerdem muss das Substrat nicht unmittelbar vor einem Druckvorgang neu lagefixiert werden. Es genügt, wenn das Substrat einmal auf dem Transportband fixiert wird. Dann kann es durch das Transportband zu einer Siebdruckstation befördert werden, ohne dass eine erneute Ausrichtung und Fixierung des Substrats notwendig ist. Das Transportband kann dabei zur Ermittlung der Lage des Substrats bzw. deren Struktur(en) in einer Siebdruckstation verwendet werden.

Ein bevorzugtes Ausführungsbeispiel der Erfindung ist in der Zeichnung schematisch dargestellt und wird nachfolgend mit Bezug zu den Figuren der Zeichnung näher erläutert.

Es zeigen:
- Fig. 1: die Draufsicht auf ein Drucksieb;
- Fig. 2: einen vergrößerten Ausschnitt des Drucksiebs der Fig. 1;
- Fig. 3: eine Schnittdarstellung durch einen Teil einer Siebdruckanlage;
- Fig. 4: einen vergrößerten Ausschnitt der Fig. 3;
- Fig. 5: eine schematisierte perspektivische Teilansicht einer Siebdruckanlage.

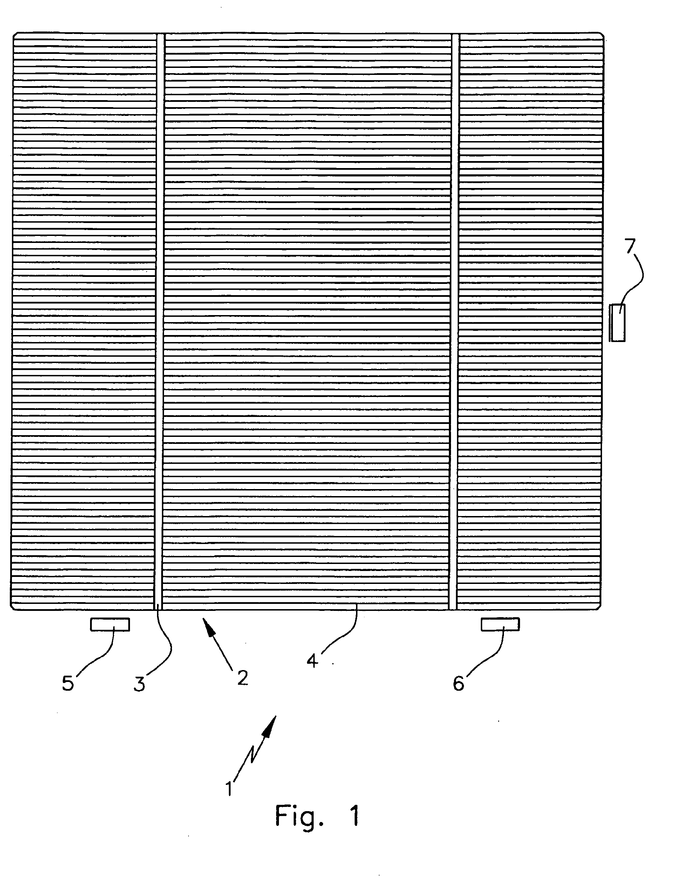

In der Fig. 1 ist ein Drucksieb 1 dargestellt, welches aufzudruckende Strukturen 2 in Form von Strukturen 3 für Stromschienen, so genannte Busbars, und Strukturen 4 für Finger von Solarzellen aufweist. Die Strukturen 2, 3, 4 sind im Wesentlichen Öffnungen in einer Maske oder Schablone, durch die mittels einer Rakel Druckpaste auf ein Substrat aufgebracht werden kann. In den Öffnungen kann ein hier nicht dargestelltes Gewebe angeordnet sein. Das Gewebe kann als Träger der Schablone dienen. Die Strukturen 2, 3, 4 stellen ein Druckmuster dar.

Neben den zu druckenden Strukturen sind Referenzmarken 5, 6, 7 vorgesehen, wobei die Referenzmarken 5, 6 entlang einer Seite und die Referenzmarke 7 entlang einer dazu rechtwinklig stehenden Seite der Strukturen 2 vorgesehen sind. Die Referenzmarken 5 bis 7 haben eine im Wesentlichen rechteckige Form und weisen ein lumineszierendes Material auf. Dabei wurden für die Referenzmarken 5 bis 7 Öffnungen in eine Maske, in der auch die Strukturen 2 realisiert sind, eingebracht und wurde die somit entstandene Ausnehmung anschließend mit lumineszierendem Material aufgefüllt.

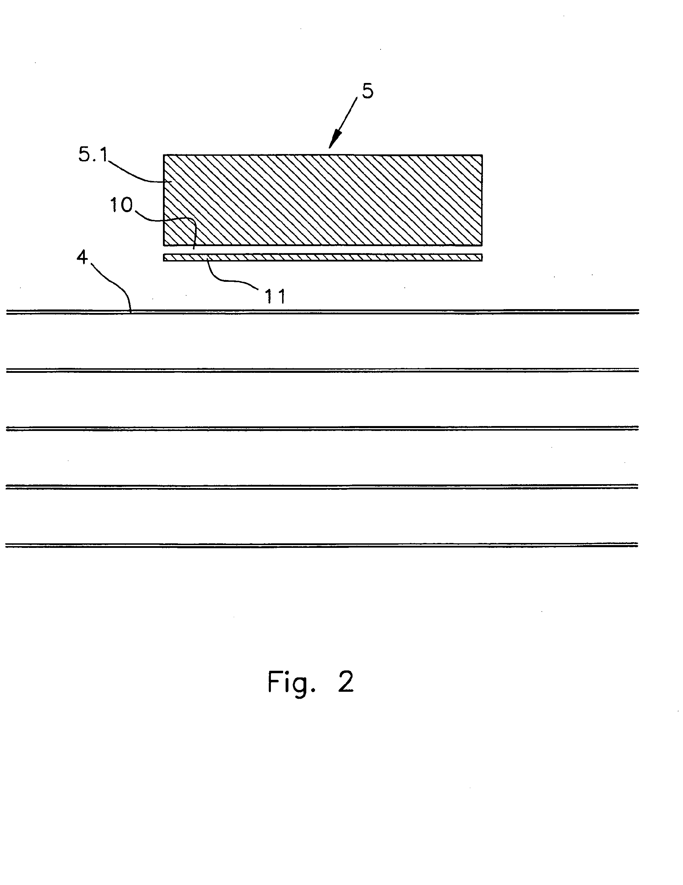

Die Fig. 2 zeigt einen vergrößerten Bereich der Fig. 1 im Bereich der Referenzmarke 5. Die Referenzmarke umfasst eine erste Referenzmarkenstruktur 5.1 und eine zweite Referenzmarkenstruktur 11, die in einem definierten Abstand von einer Kante 10 der Referenzmarkenstruktur 5 vorgesehen ist. Dadurch, dass der Abstand zwischen der Kante 10 und der Struktur 11 bekannt und vorgegeben ist, kann eine Kalibrierung eines Erfassungssystems, insbesondere einer Kamera, vorgenommen werden. Wenn nämlich mit der Kamera die Referenzmarkenstruktur 5 aufgenommen wird, so kann aufgrund des bekannten Abstands zwischen der Kante 10 und der Struktur 11 eine Größe µm/Pixel ermittelt werden. Alternativ könnte anstatt der Struktur 11 die Struktur 4 verwendet werden, mit Hilfe derer das Motiv genau positioniert aufgedruckt werden kann, wenn der Abstand zwischen der Kante 10 und der Struktur 4 bekannt ist.

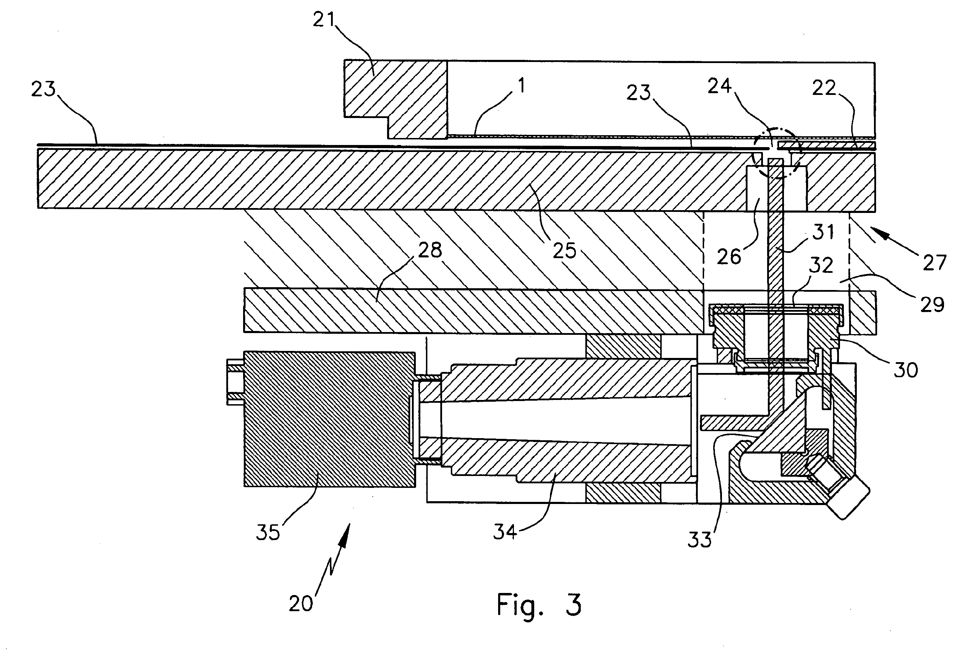

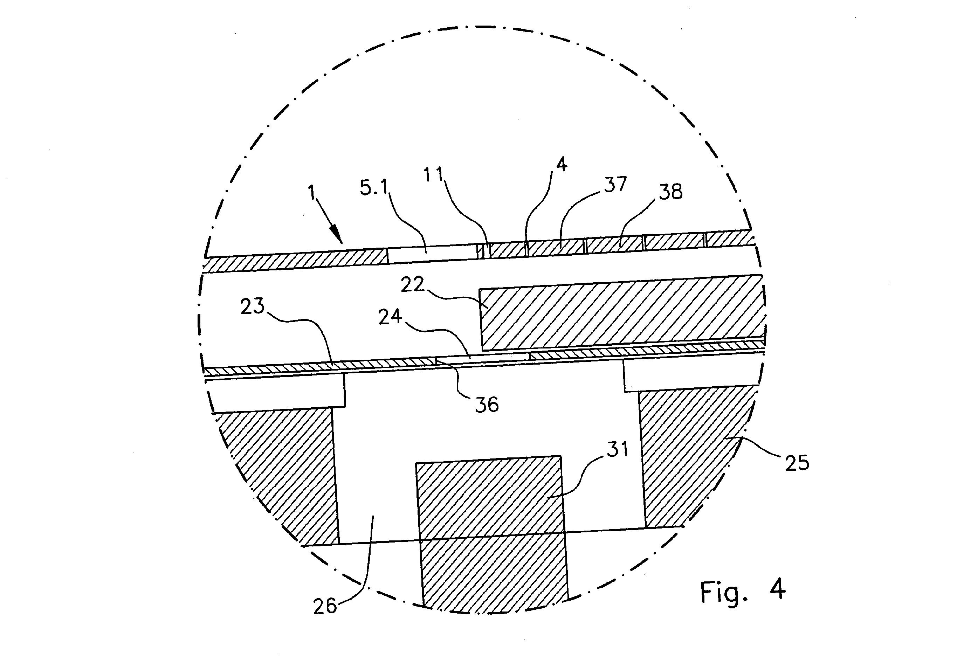

Fig. 3 zeigt eine teilweise Schnittdarstellung einer Siebdruckanlage 20 in stark schematisierter Darstellung. Das Drucksieb 1 ist in einen Siebrahmen 21 eingespannt und befindet sich oberhalb eines Substrats 22. Das Substrat 22 wiederum liegt auf einem Transportband 23 auf. In der gezeigten Darstellung überlappt das Substrat 22 teilweise eine Öffnung 24 im Transportband 23 (besser zu sehen im vergrößerten Ausschnitt der Fig. 4). Das Transportband 23 liegt auf einer Kunststoffbandauflage 25 auf. Die Kunststoffbandauflage 25 weist wiederum eine Öffnung 26 auf. Die Öffnung 26 hat zwei Abschnitte von unterschiedlichem Durchmesser. Das Transportband 23 und die Kunststoffbandauflage 25 sind Bestandteile eines Transportsystems 27, wobei das Transportband 23 relativ zur ortsfesten Kunststoffbandauflage 25 bewegbar ist. Das Transportsystem 27 befindet sich oberhalb eines ortsfesten Drucktisches 28, der ebenfalls eine Öffnung 29 aufweist. In der Öffnung 29 ist eine Beleuchtungseinrichtung 30 angeordnet. Die Beleuchtungseinrichtung 30 ist ringförmig ausgestaltet und strahlt vorzugsweise blaues Licht in Richtung Sieb 1.

Das von der Beleuchtungseinrichtung 30 ausgestrahlte blaue Licht gelangt durch die Öffnungen 26, 24 auf eine der Referenzmarken 5 bis 7 des Siebs 1. Von dem lumineszierenden Material einer der Referenzmarken 5 bis 7 wird Licht entlang des optischen Wegs 31 abgestrahlt.

Das von einer der Referenzmarken 5 bis 7 abgestrahlte Licht wird durch ein optisches Filter 32, das als Gelbfilter ausgebildet sein kann und das vorzugsweise konzentrisch zu der Beleuchtungseinrichtung 30 angeordnet ist, gefiltert. Das gefilterte Licht wird von einem Spiegel 33 umgelenkt und gelangt durch ein Objektiv 34 in eine Kamera 35. In der Kamera 35 oder einer nachgeschalteten Auswerteanordnung, beispielsweise einer Bildverarbeitungseinheit, wird das so abgestrahlte Licht hinsichtlich der Position der Referenzstruktur 36 (Fig. 4) analysiert. Im Ausführungsbeispiel ist die Referenzstruktur 36 eine oder mehrere Kanten der Öffnung 24 des Transportbandes 23. Das optische Filter 32, der Spiegel 33, das Objektiv 34 und die Kamera 35 sind Bestandteile einer Lichterfassungsanordnung. Um die genaue Position und Lage des Transportbandes 23 und damit des Substrats 22 bzw. der Strukturen auf dem Substrat 22 erfassen zu können, sind für jedes Sieb 1 vorzugsweise drei Lichterfassungsanordnungen vorgesehen. Insbesondere ist jeder Referenzmarke 5 bis 7 des Siebes 1 eine Lichterfassungsanordnung zugeordnet.

Der mit einem Kreis markierte Ausschnitt der Fig. 3 ist in der Fig. 4 vergrößert dargestellt. In der Fig. 4 sind insbesondere die Referenzmarkenstruktur 5.1 und die Struktur 11 sowie die zu druckende Struktur 4 zu erkennen. Im Ausführungsbeispiel umfasst das Sieb 1 eine Schablone 37, die auf einem siebartigen Träger 38, insbesondere einem Kunststoff- oder Metallgewebe, angeordnet ist. Die Strukturen 5, 11 sind mit lumineszierendem Material gefüllt. Sie sind daher verschlossen, sodass keine Druckpaste durch diese Strukturen 5, 11 gedruckt werden kann. Druckpaste gelangt durch die Struktur 4 auf das Substrat 22, sodass dort Elektroden entsprechend der Struktur 4 entstehen.

Es ist zu erkennen, dass die Referenzmarke 5 überlappend mit der Öffnung 24 des Transportbands 23 angeordnet ist und so angeordnet ist, dass sie von Licht der Beleuchtungseinrichtung 30 angestrahlt werden kann.

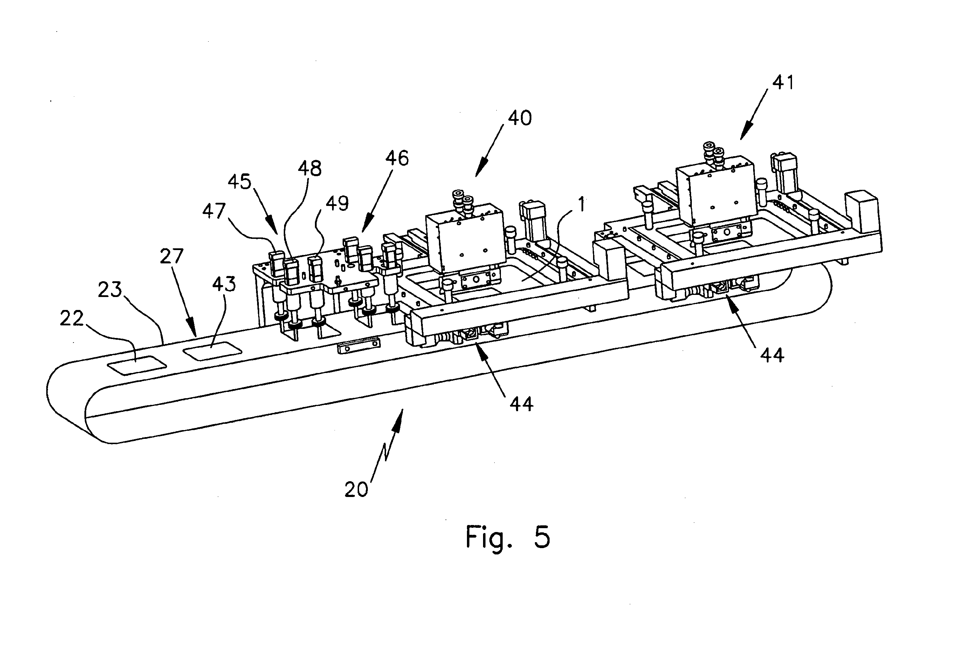

Die Fig. 5 zeigt stark schematisiert eine perspektivische Ansicht einer Siebdruckanlage 20. Die Siebdruckanlage 20 weist zwei Druckstationen 40, 41 auf. Die Druckstationen 40, 41 sind in Serie hintereinander angeordnet. In jeder Druckstation 40, 41 wird jedoch nur eines von zwei nebeneinander auf dem Transportsystem 27 abgelegten Substraten 22, 43 bedruckt. Jede der Druckstationen 40, 41 weist drei Lichterfassungsanordnungen 44 auf. Die Lichterfassungsanordnungen 44 sind unterhalb des Substrats bzw. des Transportsystems 27 angeordnet. Da jedoch das von den Referenzmarken ausgestrahlte Licht analysiert wird, wird dennoch eine Durchlichtmessung durchgeführt.

Den Druckstationen 40, 41 vorgelagert sind zwei Positionserfassungsanordnungen 45, 46. Durch die Positionserfassungsanordnungen 45, 46, die jeweils drei als Kameras ausgebildete Erfassungsmittel 47 bis 49 aufweisen, wird zum einen eine in einem vorherigen Prozessschritt ein- oder aufgebrachte Struktur, z B. eine geätzte Vertiefung, auf einem Substrat 22, 43 erfasst und zum anderen eine Referenzstruktur 36 im Transportband 23 erfasst. Die Erfassung der Referenzstruktur 36 des Transportsystems 27 erfolgt ebenfalls im Durchlichtverfahren. Zu diesem Zweck sind unterhalb des Transportsystems 27 Beleuchtungseinrichtungen (nicht dargestellt) vorgesehen. Durch die Erfassung der Struktur(en) auf den Substraten 22, 43 und der Referenzstruktur 36 des Transportsystems 27 kann die Lage der Struktur auf dem Substrat 22, 43 relativ zur Referenzstruktur 36 ermittelt werden. In den nachfolgenden Druckstationen 40, 41 ist es somit ausreichend, nur die Referenzstruktur 36 des Transportsystems 27 zu erfassen. Da die Substrate 22, 43 auf dem Transportsystem 27 fixiert sind, kann allein aufgrund der Erfassung der Referenzstruktur 36 auf die Lage von Strukturen auf den Substraten 22, 43 geschlossen werden und daraufhin das Drucksieb 1 entsprechend ausgerichtet werden. Die Ausrichtung bzw. Verstellung des Drucksiebs 1 erfolgt maschinell durch eine nicht dargestellte Verstellanordnung, die Verstellsignale der Lichterfassungsanordnungen 44 oder einer nachgeordneten Auswerteeinrichtung bzw. Steuerung empfangen kann.

## Patentansprüche

1. Drucksieb (1) für ein Siebdruckverfahren mit einer Referenzmarke (5 - 7), **dadurch gekennzeichnet, dass** die Referenzmarke (5 - 7) ein lumineszierendes Material aufweist.

2. Drucksieb nach Anspruch 1, **dadurch gekennzeichnet, dass** das Drucksieb (1) eine Referenzmarkenausnehmung aufweist, die mit dem lumineszierenden Material gefüllt ist.

3. Drucksieb nach einem der vorhergehenden Ansprüche, **dadurch gekennzeichnet, dass** die Referenzmarke (5 - 7) oder eine Referenzmarkenstruktur (51), insbesondere eine Kante (10) der Referenzmarke (5 - 7), einen vorgegebenen Abstand zu einer Struktur (11, 4) des Siebs (1) aufweist.

4. Verfahren zur Einstellung der relativen Lage eines Druckmusters und eines Substrats (22, 43) oder einer Struktur eines Substrats (22, 43), bei dem von einer lumineszierenden Referenzmarke (5 bis 7) eines das Druckmuster aufweisenden Siebs (1) ausgesandtes Licht in einem Bereich einer Referenzstruktur (36), die mit der Ist-Position des Substrats (22,43) oder der Struktur des Substrats (22, 43) in Beziehung steht, erfasst wird und das erfasste Licht hinsichtlich der Ist-Lage der Referenzstruktur (36) ausgewertet und daraus die Verstellsignale für die Verstellung des Drucksiebes (1) abgeleitet werden.

5. Verfahren nach Anspruch 4, **dadurch gekennzeichnet, dass** die Ist-Lage einer Referenzkante eines das Substrat (22, 43) transportierenden Transportsystems (27) erfasst wird.

6. Verfahren nach einem der vorhergehenden Ansprüche 4 oder 5, **dadurch gekennzeichnet, dass** die Relativposition des Substrats (22, 43) oder einer Struktur des Substrats (22, 43) zu einer Referenzkante des Transportsystems (27) ermittelt wird.

7. Verfahren nach einem der vorhergehenden Ansprüche 4 bis 6, **dadurch gekennzeichnet, dass** die Relativposition des Substrats (22, 43) oder einer Struktur des Substrats (22, 43) zu einer Referenzkante des Transportsystems (27) in einem Durchlichtverfahren ermittelt wird.

8. Verfahren nach einem der vorhergehenden Ansprüche 4 bis 7, **dadurch gekennzeichnet, dass** Licht von einer Beleuchtungseinrichtung (30) in Richtung lumineszierender Referenzmarke (5 - 7) des Siebs (1) gestrahlt wird und das von der Referenzmarke (5 - 7) abgestrahlte Licht gefiltert wird.

9. Verfahren nach einem der vorhergehenden Ansprüche 4 bis 8, **dadurch gekennzeichnet, dass** zur Bestrahlung der Referenzmarke (5 - 7) Licht eines anderen Wellenlängenbereichs verwendet wird als für die Erfassung der Referenzstruktur (36).

10. Siebdruckstation (40, 41) mit einem Drucksieb (1) und einer Lichterfassungsanordnung (44), **dadurch gekennzeichnet, dass** ein Drucksieb (1) nach einem der vorhergehenden Ansprüche 1 bis 3 vorgesehen ist.

11. Siebdruckstation nach Anspruch 10, **dadurch gekennzeichnet, dass** eine Beleuchtungseinrichtung (30) zum Bestrahlen einer Referenzmarke (5 - 7) des Drucksiebs (1) mit einem ersten Wellenlängenbereich und ein optisches Filter (32) zur Filterung des von der Referenzmarke (5 - 7) abgesandten Lichts in einem zweiten Wellenlängenbereich vorgesehen ist.

12. Siebdruckstation nach Anspruch 11, **dadurch gekennzeichnet, dass** die Beleuchtungseinrichtung (30) ringförmig ausgebildet ist und das optische Filter (32) umgibt.

13. Siebdruckstation nach einem der vorhergehenden Ansprüche 10 bis 12, **dadurch gekennzeichnet, dass** ein Transportsystem (27) zum Transport eines zu bedruckenden Substrats (22, 43) vorgesehen ist, wobei das Transportsystem (27) eine Referenzstruktur (36) aufweist, und eine Lichterfassungsanordnung vorgesehen ist, die von der lumineszierenden Referenzmarke (5 - 7) des Drucksiebs (1) ausgesandtes Licht in einem Bereich einer Referenzstruktur (36), die mit der Ist-Position der Struktur des Substrats(22, 43) in Beziehung steht, erfassen kann.

14. Siebdruckstation nach Anpruch 13, **dadurch gekennzeichnet, dass** das Transportsystem (27) ein Transportband (23) umfasst und die Referenzstruktur (36) als Kante einer Öffnung (24) im Transportband (23) ausgebildet ist.

15. Siebdruckstation nach Anspruch 14, **dadurch gekennzeichnet, dass** das Transportband (23) über einem Drucktisch (28) angeordnet ist, das Substrat (22, 43) auf dem Transportband (23) lagefixierbar ist und der Drucktisch (28) eine Öffnung (29) aufweist, innerhalb oder unterhalb der die Beleuchtungseinrichtung (30) angeordnet ist.

## Claims

1. A printing screen (1) for a screen printing process, having a reference mark (5 - 7), **characterized in that** the reference mark (5 - 7) comprises a luminescent material.

2. A screen according to Claim 1, **characterized in that** said screen (1) has a reference-mark recess, which is filled with the luminescent material.

3. A screen according to one of the preceding claims, **characterized in that** the reference mark (5 - 7) or a reference-mark structure (51), in particular an edge (10) of the reference mark (5 - 7), is at a given distance from a structure (11, 4) of the screen (1).

4. A method of adjusting the relative positions of a printing pattern and a substrate (22, 43) or a structure of a substrate (22, 43), in which light emitted from a luminescent reference mark (5 - 7) of a screen (1) having the printing pattern is detected in a region of a reference structure (36) which is related to the actual position of the substrate (22, 43) or structure of the substrate (22, 43), and the detected light is analyzed and evaluated in respect of the actual position of the reference structure (36) and adjustment signals are derived from this for adjustment of the screen (1).

5. A method according to Claim 4, **characterized in that** the actual position of a reference edge of a conveyor system (27) transporting the substrate (22, 43) is determined.

6. A method according to one of the preceding Claims 4 or 5, **characterized in that** the position of the substrate (22, 43) or a structure of the substrate (22, 43) relative to a reference edge of the conveyor system (27) is determined.

7. A method according to one of the preceding Claims 4 to 6, **characterized in that** the position of the substrate (22, 43) or a structure of the substrate (22, 43) relative to a reference edge of the conveyor system (27) is determined in a transmitted light process.

8. A method according to one of the preceding Claims 4 to 7, **characterized in that** light is beamed by an illuminating device (30) in direction of a luminescent reference mark (5 - 7) of the screen (1), and the light reflected from the reference mark (5 - 7) is filtered.

9. A method according to one of the preceding Claims 4 to 8, **characterized in that** light of a different wavelength region is used for illuminating the reference mark (5 - 7) than is used for detecting the reference structure (36).

10. A screen printing station (40, 41) with a screen (1) and a light-detecting arrangement (44), **characterized in that** a screen (1) according to one of the preceding Claims 1 to 3 is provided.

11. A screen printing station according to Claim 10, **characterized in that** an illuminating device (30) is provided for illuminating a reference mark (5 - 7) of the screen (1) with a first wavelength region, and an optical filter (32) is provided for filtering the light emitted by the reference mark (5 - 7) in a second wavelength region.

12. A screen printing station according to Claim 11, **characterized in that** the illuminating device (30) is annular in form and surrounds the optical filter (32).

13. A screen printing station according to one of the preceding Claims 10 to 12, **characterized in that** a conveyor system (27) is provided for transporting a substrate (22, 43) to be printed, the conveyor system (27) having a reference structure (36), and **in that** a light-detecting arrangement is provided, which can detect light emitted by the luminescent reference mark (5 - 7) of the screen (1) in a region of a reference structure (36) which is related to the actual position of the structure of the substrate (22, 43).

14. A screen printing station according to Claim 13, **characterized in that** the conveyor system (27) comprises a conveyor belt (23), and the reference structure (36) takes the form of an edge of an opening (24) in the conveyor belt (23).

15. A screen printing station according to Claim 14, **characterized in that** the conveyor belt (23) is placed over a printing table (28), the substrate (22, 43) can be fixed as to its position on the conveyor belt (23), and the printing table (28) has an opening (29), in which or below which the illuminating device (30) is located.

## Revendications

1. Ecran sérigraphique (1) pour un procédé de sérigraphie avec un repère de référence (5-7), **caractérisé en ce que** le repère de référence (5-7) présente un matériau luminescent.

2. Ecran sérigraphique selon la revendication 1, **caractérisé en ce que** l'écran sérigraphique (1) présente un creux pour le repère de référence qui est rempli avec le matériau luminescent.

3. Ecran sérigraphique selon une des revendications précédentes, **caractérisé en ce que** le repère de référence (5-7) ou une structure de repère de référence (51), en particulier une arête (10) du repère de référence (5-7), présente une distance prédéfinie par rapport à une structure (11, 4) de l'écran (1).

4. Procédé destiné au réglage de la position relative d'un motif d'impression et d'un substrat (22, 43) ou d'une structure d'un substrat (22, 43), dans lequel de la lumière émise par un repère de référence (5 à 7) luminescent d'un écran (1) présentant le motif d'impression est détectée dans une plage d'une structure de référence (36) qui est en relation avec la position effective du substrat (22, 43) ou de la structure du substrat (22, 43), et la lumière détectée est analysée quant à la position effective de la structure de référence (36), et les signaux de déplacement pour le déplacement de l'écran sérigraphique (1) sont dérivés de cette analyse.

5. Procédé selon la revendication 4, **caractérisé en ce que** la position effective d'une arête de référence d'un système de transport (27) transportant le substrat (22, 43) est détectée.

6. Procédé selon une des revendications précédentes 4 ou 5, **caractérisé en ce que** la position relative du substrat (22, 43) ou d'une structure du substrat (22, 43) par rapport à une arête de référence du système de transport (27) est déterminée.

7. Procédé selon une des revendications précédentes 4 à 6, **caractérisé en ce que** la position relative du substrat (22, 43) ou d'une structure du substrat (22, 43) par rapport à une arête de référence du système de transport (27) est déterminée dans un procédé par transparence.

8. Procédé selon une des revendications précédentes 4 à 7, **caractérisé en ce que** de la lumière est projetée par un dispositif d'éclairage (30) en direction du repère de référence (5-7) luminescent de l'écran (1) et **en ce que** la lumière projetée par le repère de référence (5-7) est filtrée.

9. Procédé selon une des revendications précédentes 4 à 8, **caractérisé en ce que**, pour l'illumination du repère de référence (5-7), on utilise de la lumière d'une plage de longueur d'onde différente de celle utilisée pour la détection de la structure de référence (36).

10. Poste de sérigraphie (40, 41) avec un écran sérigraphique (1) et un dispositif de détection de lumière (44), **caractérisé en ce qu'**il est prévu un écran sérigraphique (1) selon une des revendications précédentes 1 à 3.

11. Poste de sérigraphie selon la revendication 10, **caractérisé en ce qu'**il est prévu un dispositif d'éclairage (30) pour l'éclairage d'un repère de référence (5-7) de l'écran sérigraphique (1) avec une première plage de longueur d'onde et un filtre optique (32) pour le filtrage de la lumière émise par le repère de référence (5-7) dans une deuxième plage de longueur d'onde.

12. Poste de sérigraphie selon la revendication 11, **caractérisé en ce que** le dispositif d'éclairage (30) est réalisé sous forme annulaire et entoure le filtre optique (32).

13. Poste de sérigraphie selon une des revendications précédentes 10 à 12, **caractérisé en ce qu'**il est prévu un système de transport (27) pour le transport d'un substrat (22, 43) à imprimer, le système de transport (27) présentant une structure de référence (36), et **en ce qu'**il est prévu un dispositif de détection de lumière qui peut détecter la lumière émise par le repère de référence (5-7) luminescent de l'écran sérigraphique (1) dans une plage d'une structure de référence (36) qui est en relation avec la position effective de la structure du substrat (22, 43).

14. Poste de sérigraphie selon la revendication 13, **caractérisé en ce que** le système de transport (27) comprend une bande de transport (23) et **en ce que** la structure de référence (36) est réalisée sous forme d'arête d'une ouverture (24) dans la bande de transport (23).

15. Poste de sérigraphie selon la revendication 14, **caractérisé en ce que** la bande de transport (23) est disposée au-dessus d'une table d'impression (28), **en ce que** le substrat (22, 43) peut être fixé en position sur la bande de transport (23), et **en ce que** la table d'impression (28) présente une ouverture (29) à l'intérieur de laquelle ou au-dessous de laquelle le dispositif d'éclairage (30) est disposé.
